Europäisches Patentamt

European Patent Office

Office européen des brevets

(11) Publication number: **0 145 038**
**B1**

# (12) EUROPEAN PATENT SPECIFICATION

(45) Date of publication of patent specification: **23.11.89**

(51) Int. Cl.⁴: **H 04 M 15/00**

(21) Application number: **84201344.3**

(22) Date of filing: **15.09.84**

(54) **Electronic circuits and signal generator using them.**

(30) Priority: **19.09.83 BE 2060207**

(43) Date of publication of application:
**19.06.85 Bulletin 85/25**

(45) Publication of the grant of the patent:
**23.11.89 Bulletin 89/47**

(84) Designated Contracting States:
**AT CH DE FR GB IT LI NL SE**

(56) References cited:
**EP-A-0 076 733**
**DE-B-1 299 699**
**GB-A-2 103 041**

(73) Proprietor: **BELL TELEPHONE
MANUFACTURING COMPANY Naamloze
Vennootschap
Francis Wellesplein 1
B-2018 Antwerp (BE)**
(84) **NL**

(73) Proprietor: **ALCATEL N.V.
Strawinskylaan 537 (World Trade Center)
NL-1077 XX Amsterdam (NL)**
(84) **CH DE FR GB IT LI SE AT**

(72) Inventor: **Rabaey, Dirk Herman Lutgardis
Cornelius
Bikschotelaan 254
B-2200 Borgerhout (BE)**
Inventor: **Haspeslagh, Didier René
Tieltsestraat 10
B-8750 Harelbeke (BE)**

(74) Representative: **Vermeersch, Robert et al
BELL TELEPHONE MANUFACTURING
COMPANY Naamloze Vennootschap Patent
Department Francis Wellesplein 1
B-2000 Antwerp (BE)**

Courier Press, Leamington Spa, England.

# Description

The present invention relates to a signal generator for generating a signal with pulses having sloping edges.

Such a signal generator is well known in the art. When operational amplifiers are used therein to realize the sloping pulse edges it may happen, due to a possible offset of the amplifiers, that the signal has an unwanted high amplitude in the time intervals between the pulses. This can be a nuisance in certain applications and give rise to noise.

An object of the present invention is to provide a signal generator of the above type, but which does not present this drawback, i.e. wherein the amplitude of the signal generated has a predetermined amplitude, e.g. 0 Volt, in the interpulse time intervals.

According to the invention this object is achieved due to the fact that a generator circuit which generates a second signal having in the interpulse time intervals of said first mentioned signal such an amplitude with respect to said first signal that these interpulse intervals may be detected by a detector circuit detecting said amplitude difference and that in response thereto the amplitude of said first signal in said interpulse intervals is limited by a limiting circuit to a reference voltage.

By thus choosing the amplitude difference voluntary high during the interpulse time intervals, the latter are easily detected by the detector circuit and this information is used by the limiting circuit to bring the generator output on the wanted reference value.

Another characteristic feature of the signal generator according to the invention is that it is coupled, on the one hand with said detector circuit which is constituted by a comparator circuit and on the other hand with a generator output which is coupled with said limiting circuit controlled by said comparator circuit, all in such a way that when both said signals are applied to said comparator circuit the pulse periods and the interpulse time intervals of said first signal are detected as a consequence of which said comparator circuit controls said limiting circuit in such a manner that the latter limits said amplitude to said reference value in said interpulse time intervals.

Still another characteristic of the present signal generator is that it includes: a pulse source which generates opposite first and second pulse waveforms, as well as a modulator circuit with a pair of first modulator inputs to which said first and second signals are applied respectively, with a pair of second modulator inputs to which said first and second pulse waveforms are applied, and with a modulator output which is coupled with said generator output, said first modulator inputs being coupled via a third and a fourth gating circuit to said modulator output respectively and said second modulator inputs constituting control inputs of said third and fourth gating circuits respectively, such that a pulse waveform modulated by said first and second signals is generated at said modulator output.

Yet another characteristic of the present signal generator is that said opposite first and second pulse waveforms are pulse density modulated pulse waveforms and that said generator output is coupled with a filter device including a lowpass filter to transform said modulated pulse waveform into a modulated sine waveform.

Still other characteristics of the signal generator according to the invention is that said filter device also includes a bandpass filter to allow the passage of said sine waveform and to limit the amount of power in the lower frequency region thereof.

Still another characteristic of the present signal generator are that the lower frequency region is the speech region, that the first and second signals are mutually inverse and that the modulated sine wave is used as a metering signal for telecommunication purposes.

Because this metering signal has the wanted reference value, e.g. 0 Volt, in the time intervals between the pulse constituted by sine waves, during these time intervals it cannot be considered in the telephone subset as an effective metering signal, as would be the case if the signal would have a considerable amplitude in these time intervals. Also this signal does not produce clicks in the telephone subset because on the one hand the pulses constituted by the sine waves have sloping edges reducing the amount of power in the speech region and which is responsible for such clicks, and on the other hand because the bandpass filter further reduces this amount of power.

Still another characteristic of the present invention is that said first comparator inputs are coupled with first and second inputs of first and second inverters via fifth and sixth gating circuits, said inverters being coupled in a closed loop, a DC source being coupled via said inverters through a gating device and said complementary comparator outputs being constituted by the inverter inputs.

The invention also relates to a comparator circuit with a first and a second input and with complementary first and second outputs, characterized in that said first and second inputs are coupled with first and second inputs of first and second inverters via first and second gating circuits, said inverters being coupled in a closed loop, a DC source being coupled via said inverters through a gating device and said complementary outputs being constituted by the inverter outputs.

The invention also relates to a modulator circuit with pairs of first and second inputs and with an output, characterized in that each of said first inputs is coupled with said output via first and second gates and that said second inputs constitute respective control inputs of said first and second gates.

The above mentioned and other objects and features of the invention will become more apparent and the invention itself will be best understood by referring to the following description of embodiments taken in conjunction with the accompanying drawings wherein:

Fig. 1 represents a pulse generator MSG according to the invention;

Fig. 2 shows waveforms PW and BSO appearing at terminals PW and BSO of Fig. 1 respectively;

Fig. 3 represents comparator CO of Fig. 1 and according to the invention in detail;

Fig. 4 shows pulse waveforms PW1 to PW3 controlling this comparator CO.

The signal generator MSG shown is a metering signal generator. It forms part of a transcoder and filter circuit which is itself included in a telephone line circuit connected between a telephone line, coupled to a telephone subset, and a telephone switching network and comprising the cascade connection of a subscriber line interface circuit, able to perform line control and supervision, a digital signal processor adapted to execute analog-to-digital and digital-to-analog conversion operations, the above transcoder and filter circuit which is able to generate a metering signal and moreover to transform 13-bit linear PCM signals into 8-bit companded PCM signals and vice-versa, and a dual processor terminal controller to ensure the general control of the line circuit. The transcoder and control circuits are provided in common for eight associated subscriber line interface circuits and digital signal processors.

As will be explained hereinafter the metering signal able to be generated by MSG comprises bursts of 12 kHz or 16 kHz sine waves which are symmetrical about a 0 Volts reference and have a minimum length of 100 milliseconds. In order that these bursts should not produce audible click in the telephone subset they have gradually varying leading and trailing edges and are moreover suitably filtered, both measures decreasing the power in the audible frequency region of the signal which is responsible for such audible clicks.

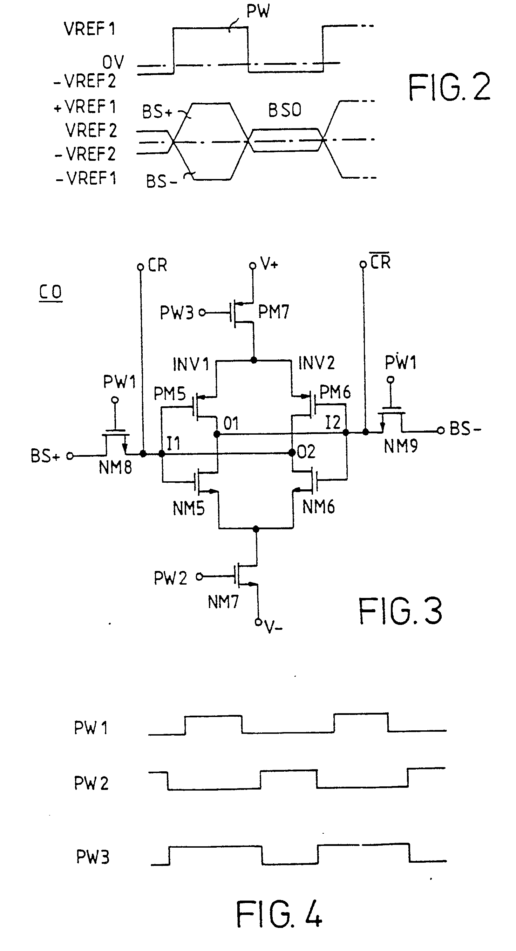

The metering signal generator MSG shown includes a pulse source PS providing at its outputs PW, PDM and PW1 to PW3 a pulse waveform PW (Fig. 2), a Pulse Density Modulated (PDM) binary signal PDM (not shown) and pulse waveforms PW1 to PW3 (Fig. 4) respectively. Pulse waveform PW has a frequency of 3.13 Hz and an amplitude varying between reference voltages −VREF2=−0.7 Volts and +VREF1=+2.5 Volts. The binary signal PDM has an amplitude varying between V−=−5 Volts, and 0 Volt and a selectable frequency of 4096 kHz or of 2048 kHz and is such that when it is passed through a suitable lowpass filter a pure sine wave with a frequency of 12 kHz or 16 kHz is obtained respectively. The pulse waveforms PW1 to PW3 vary between −5 Volts and V+=+5 Volts and have a frequency of 256 kHz.

The pulse waveform PW is applied to the like named non-inverting input of an operational amplifier OA1 forming part of a burst signal generator BSG with outputs BS+ and BS− and which further includes constant current sources CS1 and CS2, operational amplifiers OA2 and OA3, resistors R1 and R2 of equal value and capacitor C. As schematically indicated by the arrows, the output of OA1 controls the current sources CS1 and CS2, which are connected in series between V+ and V−. The junction point of CS1 and CS2 is connected to the inverting input of OA1, to ground via capacitor C and finally to the non-inverting input of unity gain amplifier OA2 which isolates capacitor C from the output of OA2. This output is connected via resistor R1 to the inverting input of OA3 whose output is connected to its inverting input through feedback resistor R2 and whose non-inverting input is grounded. The outputs of OA2 and OA3 constitute the above mentioned outputs BS+ and BS− respectively.

When the pulse waveform PW is applied to BSG, capacitor C is charged in a linear way by the constant current provided by current source CS1 until its voltage reaches +VREF1 or is discharged in a linear way by the constant current flowing to V− through current source CS2 until its voltage reaches −VREF2. Between these charging and discharging operations the capacitor remains at +VREF1 or at −VREF2. Thus an asymmetrical pulse waveform BS+ which alternately extends at different sides of 0 Volts as shown in Fig. 2, is obtained, the pulses of this signal BS+ having linearly rising end decaying edges with rise and decay times equal to about 20 milliseconds. The constant amplitude portions between these edges each have a minimum duration of 100 milliseconds.

To obtain a pulse waveform which varies symmetrically about 0 Volt, the unsymmetrical pulse waveform BS+ at the output of capacitor C is first reproduced at the output BS+ of OA2 and then inverted in OA3. The latter generates at its output BS− the like named pulse waveform BS− varying between +VREF2 and −VREF1 and also alternately extending at different sides of 0 Volt as shown in Fig. 2.

These pulse waveforms BS+ and BS− are now applied to the like name control inputs of a modulator circuit MOD comprising two switches S1 and S2 each with a PMOS transistor PM1/2 and an NMOS transistor NM1/2. The first and second control inputs of these switches S1/S2 are constituted by the gate electrodes of the transistors PM1/2 and NM1/2 respectively; their data inputs are constituted by the interconnected source of PM1/NM2 and drain of NM1/PM2; and their data outputs are constituted by the commoned drain of PM1/NM2 and source of NM1/PM2. Output BS+ and BS− of BSG are connected to the data inputs of S1 and S2 whose data outputs are commoned and constitute the output BSO of the modulator circuit MOD. The inputs PDM1/2 thereof are constituted by the commoned first/second and second/first control inputs of the switches S1 and S2. The output PDM of the pulse source PS is connected to the input of a level shifter and inverter circuit LSIC having two outputs PDM1 and PDM2 connected to the like named inputs of the modulator circuit MOD respectively.

In circuit LSIC the level of the pulse waveform PDM varying between 0 Volts and V— is shifted so that a pulse waveform PDM1 varying between V+ and V— is obtained and PDM1 is then inverted to produce pulse waveform PDM2. These two opposite pulse waveforms PDM1 and PDM2 are such that they close either switch S1 or S2 of the modulator circuit MOD, thus applying either BS+ or BS— to the output BSO thereof. As a consequence the PDM pulse waveform BSO at this output BSO is symmetrical about 0 Volts and limited between BS and —BS. In Fig. 2, the envelope of this PDM pulse waveform BSO is represented, this envelope varying between +VREF1 and —VREF1 in the pulse or burst periods and between VREF2 and —VREF2 in the time intervals between these pulses. These pulse periods and interpulse time intervals are determined by the crossings of BS+ and BS— which occur on the 0 Volt axis.

Only the PDM signals in the burst periods will be used as metering signals. Therefore the PDM signals in the interpulse time intervals and which could be interpreted in the telephone subset as metering pulses should be eliminated. For this reason the above output signals BS+ and BS— are also applied to the like named inputs of a comparator CO which has outputs CR and $\overline{CR}$ and is shown in detail in Fig. 3. This comparator CO includes two identical inverters INV1 and INV2 comprising PMOS and NMOS transistors PM5, NM5 and PM6, NM6 respectively. The gate electrodes of the pair of transistors PM5 and NM5, as well as those of the pair of transistors PM6 and NM6 are commoned and constitute the inverter inputs I1 and I2 respectively, and the drain electrodes of the transistors of each of these pairs are also commoned and constitute the inverter outputs O1 and O2 respectively. The inverter output O2 is connected to the inverter input I1 and the inverter output O1 is like connected to the inverter input I2. The supply voltage V+ is connected to the interconnected source electrodes of PM5 and PM6 and the source-to-drain path of PMOS transistor PM7 which is controlled by pulse waveform PW3 (Fig. 4), and the commoned source electrodes of NM5 and NM6 are connected to V— through the drain-to-source path of NMOS transistor NM7 which is controlled by PW2 (Fig. 2). The input BS— of the comparator circuit CO is connected to the input I2 of INV2 through the drain-to-source path of NMOS transistor NM9, whilst the input BS+ is likewise connected to I1 via NM8. Transistors NM8 and NM9 are both controlled by pulse waveform PW1 (Fig. 4). The above inverter inputs I1 and I2 constitute the outputs CR and $\overline{CR}$ of the comparator CO respectively.

This comparator circuit CO operates as follows when the pulse waveforms BS+ and BS— are applied to the like named inputs thereof.

When PW1 is activated (1) the waveform BS+ and BS— are applied to the inverter inputs I1 and I2 via NM8 and NM9 respectively and are thus sampled since they are stored in the parasitic input capacitances which are present at these inputs. Afterwards, when PW2 is brought on 1 and PW3 on 0, both the inverters are made operative as both PM7 and NM7 then become conductive as a consequence of which V+ and V— are applied to the drain electrodes of PM5, PM6 and of NM5, NM6 respectively so that both the inverters become operative. Hence, when BS+ is larger than BS—, NM5 and PM6 become fully conductive due to the amplifying action of the interconnected inverters. As a consequence the outputs CR and $\overline{CR}$ are then substantially at the voltages V+ and V— respectively i.e. they are activated (1) and deactivated (0) respectively. On the contrary, when BS— is larger than BS+, then $\overline{CR}$ and CR are activated and deactivated respectively.

From the above it follows that when the sign of (BS+)—(BS—) changes, the comparator output varies from 1 to 0 or vice-versa whilst output $\overline{CR}$ simultaneously changes from 0 to 1 and vice-versa. Thus the pulse periods and interpulse time intervals of pulse waveform BSO are characterized by CR=1, $\overline{CR}$=0 and CR=0, $\overline{CR}$=1 respectively.

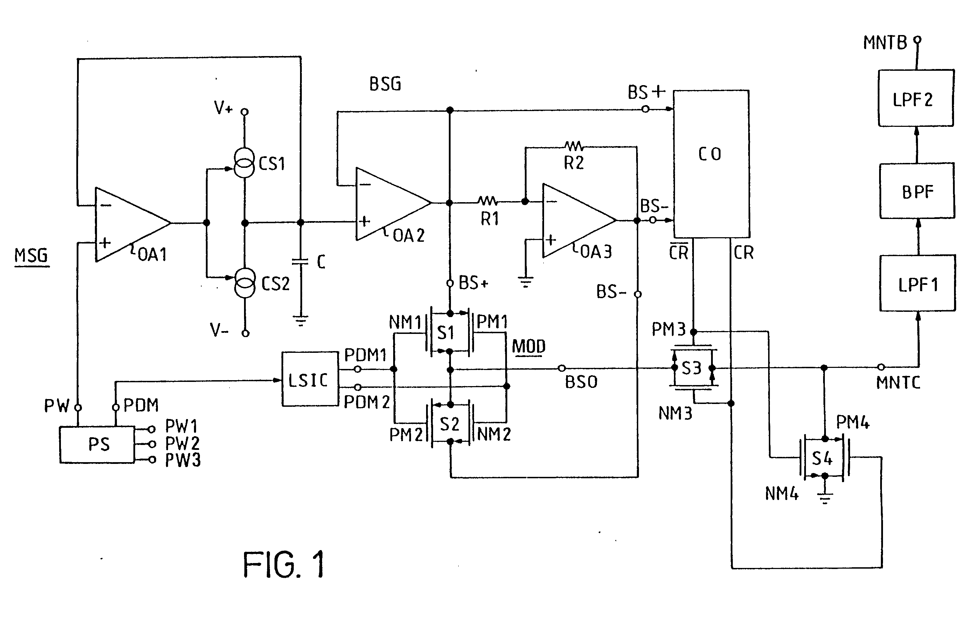

Returning to Fig. 1, the outputs CR and $\overline{CR}$ of CO are connected to the control inputs of switches S3 and S4 which are similar to the switches S1 and S2 and comprise PMOS and NMOS transistors PM3, NM3 and PM4, NM4 respectively. The data input of S3 is connected to the above mentioned output BSO of the modulator circuit MOD and its data output is connected to output terminal MNTC and to the data input of S4 whose data output is grounded. The first control input of S3 and the second one of S4 are connected to output $\overline{CR}$ of CO, whilst the second control input of S3 and the first one of S4 are connected to output CR of CO.

As described above, CR=1 and $\overline{CR}$=0 during the pulse periods of BSO so that switches S3 and S4 are then closed and open respectively and the output signal BSO appears at output terminal MNTC. On the contrary, in the interpulse time intervals of BSO, $\overline{CR}$=1 and CR=0 due to which switches S3 and S4 are open and closed respectively. Thus the output BSO is then disconnected from terminal MNTC and the latter is grounded.

From the above it follows that starting from a pulse waveform PW which varies between —VREF2 and +VREF1 pulse waveforms BS+ and BS— have been generated which vary between —VREF2 and +VREF1 and between +VREF2 and —VREF1 respectively, so that it is then easy to detect the crossings of both these waveforms and use this information to limit the amplitude of the PDM waveform BSO e.g. to zero between in the interpulse time intervals thereof.

The reason for proceeding in this way is the following. When one could start from a pulse waveform PW varying between VREF2=0 Volts and VREF1 then it could happen that due to a possible offset of OA1 and/or of OA2 the lower level of BS+ in the interpulse time intervals is not at 0 Volt but lower, say at −ΔV1. Due to a possible offset of OA3 and the inversion therein it could also happen that the upper level of BS− in the interpulse time intervals is at a higher value than 0 Volt, say +ΔV2. When the difference between +ΔV2 and −ΔV1 is sufficiently large the PDM signal in the interpulse time intervals could then be interpreted in the telephone subset as a metering signal. By forcing now the level of BS+ and BS− in the interpulse time intervals to values which are equal to −VREF2 and +VREF2 independently of the operational amplifiers OA1—OA3 having an offset or not, considerable amplitudes of BS+ and BS− are realised so that even when these amplifiers have an offset (always smaller than VREF2=0.7 Volts) it will always be possible to detect these amplitudes in the way described above and then limit the voltage amplitude of BSO to zero in the interpulse time intervals.

Because the leading and trailing edges of the bursts of the PDM signal in the above metering signal BSO generated at the output MNTC vary slowly, the amount of power contained in the audible frequency region of the metering signal is relatively small and because this power is responsible for audible clicks in the telephone subset also the danger of occurrence of such clicks is thus reduced. However, this measure is still insufficient as this amount of power is still too high. To further reduce its use is made of a filter device which is branched between terminal MNTC and the output terminal MNTB of the generator and includes the cascade connection of lowpass filter LPF1, bandpass filter BPF and lowpass filter LPF2. Filter LPF1 is a simple RC filter and is used as an anti-aliasing filter. Bandpass filter BPF is a sixth order switched-capacitor filter and comprises the cascade connection of a second order lowpass filter and of a fourth order bandpass filter proper (both not shown). This lowpass filter has a cut off frequency at 20 kHz and operates at a sampling frequency of 4096 kHz. It transforms the PDM waveform BSO into a waveform with bursts of a 12 kHz or 16 kHz sine wave and acts as an anti-aliasing filter for the bandpass filter proper which has a flat characteristic in a region covering 12 kHz to 16 kHz and operates at a sampling frequency of 256 kHz. The function of this filter is to pass the 12 kHz or 16 kHz sine wave and provide a further attenuation of the amount of power in the audible frequency region of the above signal BSO. Lowpass filter LPF2 is a so-called Rauch filter with a cut-off frequency of 50 kHz. This filter is well known in the art and is used to suppress in the output signal at MNTB residual signals produced by the switched-capacitor filter clock of the bandpass filter BPF.

## Claims

1. Signal generator for generating a signal (BS+) with pulses having sloping edges, characterized in that it includes a generator circuit (PS, BSG) which generates a second signal (BS−) having in the interpulse time intervals of said first mentioned signal (BS+) such an amplitude with respect to said first signal (BS+) that these interpulse intervals may be detected by a detector circuit (CO) detecting said amplitude difference and that in response thereto the amplitude of said first signal in said interpulse intervals is limited by a limiting circuit (S4) to a reference voltage.

2. Signal generator according to claim 1, characterized in that said signal generator (BSG) is coupled, on the one hand with said detector circuit which is constituted by a comparator circuit (CO) and on the other hand with a generator output (MNTC) which is coupled with said limiting circuit (S4) controlled by said comparator circuit, all in such a way that when both said signals are applied to first inputs (BS+, BS−) of said comparator circuit the pulse periods and the interpulse time intervals of said first signal (BS+) are detected as a consequence of which said comparator circuit (CO) controls said limiting circuit (S4) in such a manner that the latter limits said amplitude to said reference value in said interpulse time intervals.

3. Signal generator according to claim 2, characterized in that said generator circuit (BSG) is coupled via a first gating circuit (S3) with said generator output which is coupled to said reference value through a second gating circuit (S4) which constitutes said limiting circuit, said first (S3) and second (S4) gate circuits being controlled by complementary outputs (CR, $\overline{\text{CR}}$) of said comparator circuit (CO) in such a manner that said first gating circuit (S3) allows the passage of said signals only during the pulse periods and that said second gating circuit (S4) limits the generator output (MNTC) to said reference value in the interpulse time intervals.

4. Signal generator according to claim 2, characterized in that it includes: a pulse source (PS, LSIC) which generates opposite first (PDM1) and second (PDM2) pulse waveforms, as well as a modulator circuit (MOD) with a pair of first modulator inputs (BS+, BS−) to which said first (BS+) and second (BS−) signals are applied respectively, with a pair of second modulator inputs (PDM1, PDM2) to which said first (PDM1) and second (PDM2) pulse waveforms are applied, and with a modulator output which is coupled with said generator output (MNTC), said first modulator inputs (BS+, BS−) being coupled via a third (S1) and a fourth (S2) gating circuit to said modulator output (BSO) respectively and said second modulator inputs (PDM1, PDM2) constituting control inputs of said third (S1) and fourth (S2) gating circuits respectively, such that a pulse waveform (BSO) modulated by said first (BS+) and second (BS−) signals is generated at said modulator output (BSO).

5. Signal generator according to claim 4, characterized in that said opposite first (PDM1) and second (PDM2) pulse waveforms are pulse density modulated pulse waveforms and that said generator output (MNTC) is coupled with a filter device including a lowpass filter to transform said modulated pulse waveform into a modulated sine waveform.

6. Signal generator according to claim 5, characterized in that said filter device also includes a bandpass filter (BPF) to allow the passage of said sine waveform and to limit the amount of power in the lower frequency region thereof.

7. Signal generator according to claim 6, characterized in that said lower frequency region is the speech region.

8. Signal generator according to claim 1, characterized in that said first (BS+) and second (BS−) are mutually inverse with respect to said reference value.

9. Signal generator according to claim 8, characterized in that said first (BS+) and second (BS−) signals are trapezoidal.

10. Signal generator according to claims 7 and 9, characterized in that said modulated sine waveform (BSO) is a metering signal for telecommunication purposes.

11. Signal generator according to claim 1, characterized in that said generator circuit includes a pulse source (PS) generating a rectangular pulse waveform (PW) whose envelope alternately extends at different sides of said reference value, an operational amplifier (OA1) to the non-inverting input of which said rectangular pulse waveform (PW) is applied and whose output controls the operation of first (CS1) and second (CS2) current sources which are connected in series between the poles of a DC source (V+, V−), the junction point of said sources being coupled to the inverting input of said amplifier (OA1) and to one plate of a capacitor (C) whose other plate is connected to said reference value, said first signal (BS+) being generated at said junction point.

.12. Signal generator according to claim 11, characterized in that said junction point is coupled to the non-inverting input of a unity gain second operational amplifier (OA2) and that the output of said second operational amplifier (OA2) is coupled with an inverting third operational amplifier (OA3) at the output of which said second signal (BS−) is generated.

13. Signal generator according to claims 3 and 4, characterized in that each of said gate circuits is constituted by a switch comprising two mutually coupled PMOS and NMOS transistors.

14. Signal generator according to claim 3, characterized in that said first comparator inputs (BS+, BS−) are coupled with first (I1) and second (I2) inputs of first (INV1) and second (INV2) inverters via fifth (NM8) and sixth (NM9) gating circuits, said inverters being coupled in a closed loop, a DC source being coupled via said inverters through a gating device (PM7, NM7) and said complementary comparator outputs (CR, $\overline{CR}$) being constituted by the inverter inputs (I1, I2).

15. Signal generator according to claim 14, characterized in that each of said inverters (INV1, INV2) includes a PMOS transistor (PM5, PM6) and an NMOS transistor (NM5, NM6) the gate electrodes as well as the drain electrodes of which are commoned and constitute the inverter input (I1, I2) and output (O1, O2) respectively, and the source electrodes of the PMOS transistors (PM5, PM6) and those of the NMOS transistors (NM5, NM6) being coupled with respective poles of said DC source via seventh (PM7) and eighth gating (NM7) circuits constituting said gating device, and said fifth (NM8) and sixth (NM9) gating circuits being conductive when said seventh (PM7) and eighth (NM7) gating circuits are not and vice-versa.

**Patentansprüche**

1. Signalgenerator zum Generieren eines Signals (BS+) mit Impulsen, welche abgeschrägte Flanken aufweisen, dadurch gekennzeichnet, daß er eine Generatorschaltung (PS, BSG) beinhaltet, welche ein zweites Signal (BS−) generiert, und daß er während der Zeitintervalle zwischen den Impulsen des erstgenannten Signals (BS+) bezüglich des genannten ersten Signals (BS+) eine solche Amplitude aufweist, daß diese Intervalle zwischen den Impulsen von einer Detektorschaltung (CO) durch Erkennen besagter Amlitudendifferenz erkannt werden können und daß als Ansprechreaktion darauf die Amplitude des erwähnten ersten Signals in den genannten Intervallen zwischen den Impulsen durch eine Begrenzungsschaltung (S4) auf eine Referenzspannung begrenzt wird.

2. Signalgenerator gemäß Anspruch 1, dadurch gekennzeichnet, daß der genannte Signalgenerator (BSG) einerseits mit der erwähnten Detektorschaltung, welche durch eine Komparatorschaltung (CO) gebildet wird, und andererseits mit einem Generatorausgang (MNTC), welcher mit der erwähnten durch die genannte Komparatorschaltung gesteuerten Begrenzungsschaltung (S4) gekoppelt ist, verbunden ist, und zwar jeweils so, daß, wenn beide genannten Signale an die ersten Eingänge (BS+, BS−) der erwähnten Komparatorschaltung gelegt werden, die Impulsperioden und die Zeitintervalle zwischen den Impulsen des obgenannten ersten Signals (BS+) erkannt werden, worauf als Folge dieses Erkennens die Komparatorschaltung (CO) die Begrenzungsschaltung (S4) so steuert, daß letztere besagte Amplitude während der erwähnten Zeitintervalle zwischen den Impulsen auf den genannten Referenzwert begrenzt.

3. Signalgenerator gemäß Anspruch 2, dadurch gekennzeichnet, daß die erwähnte Generatorschaltung (BSG) über eine erste Gateschaltung (S3) mit dem genannten Generatorausgang gekoppelt ist, der durch eine zweite Gateschaltung (S4) an den genannten Referenzwert gelegt wird, wodurch die genannte Begrenzungsschaltung gebildet wird, wobei erwähnte erste (S3) und zweite (S4) Gateschaltungen durch komplementäre Ausgänge (CR, $\overline{CR}$) der erwähnten Komparatorschaltung (CO) auf eine Weise gesteuert werden, daß die erste Gateschaltung (S3) nur während der Impulsperioden das Durchlaufen des genannten Signals zuläßt und daß die erwähnte zweite Gateschaltung (S4) den Generatorausgang (MNTC) während der Zeitintervalle zwischen den Impulsen auf den genannten Referenzwert begrenzt.

4. Signalgenerator gemäß Anspruch 2, dadurch gekennzeichnet, daß er eine Impulsquelle (PS, LSIC), welche gegenpolige erste (PDM1) und zweite (PDM2) Impulskurvenformen generiert, sowie eine Modulatorschaltung (MOD) mit einem Paar erster Modulatoreingänge (BS+, BS−), an welche das genannte erste (BS+) bzw. zweite (BS−) Signal gelegt wird, mit einem Paar zweiter Modulatoreingänge (PDM1, PDM2), an welche die genannten ersten (PDM1) und zweiten (PDM2) Impulskurvenformen gelegt werden, und mit einem Modulatorausgang, der mit dem genannten Generatorausgang (MNTC) gekoppelt ist, wobei die genannten ersten Modulatoreingänge (BS+, BS−) über eine dritte (S1) bzw. vierte (S2) Gateschaltung an den genannten Modulatorausgang (BSO) gekoppelt sind und die genannten zweiten Modulatoreingänge (PDM1, PDM2) Steuereingänge der genannten dritten (S1) bzw. vierten (S2) Gateschaltung dergestalt bilden, daß eine Impulskurvenform (BSO), welche von dem genannten ersten (BS+) und zweiten (BS−) Signal moduliert wird, an dem erwähnten Modulatorausgang (BSO) generiert wird, beinhaltet.

5. Signalgenerator gemäß Anspruch 4, dadurch gekennzeichnet, daß die erwähnte gegenpolige erste (PDM1) und zweite (PDM2) Impulskurvenform jeweils eine pulsdichtedulierte Impulskurvenform ist daß der erwähnte Generatorausgang (MNTC) mit einer Filtervorrichtung gekoppelt ist, welche ein Tiefpaßfilter zum Umwandeln der erwähnten modulierten Impulskurvenform in eine modulierte Sinuskurvenform beinhaltet.

6. Signalgenerator gemäß Anspruch 5, dadurch gekennzeichnet, daß die genannte Filtervorrichtung auch ein Bandfilter (BPF) beinhaltet, um das Passieren der erwähnten Sinuskurvenform zuzulassen und die Leistung in seinem unteren Frequenzbereich zu begrenzen.

7. Signalgenerator gemäß Anspruch 6, dadurch gekennzeichnet, daß dieser genannte untere Frequenzbereich der Sprachbereich ist.

8. Signalgenerator gemäß Anspruch 1, dadurch gekennzeichnet, daß die beiden genannten Signale (erstes Signal BS+) und zweites Signal (BS−)) bezüglich des genannten Referenzwertes einander gegenpolig sind.

9. Signalgenerator gemäß Anspruch 8, dadurch gekennzeichnet, daß die beiden genannten Signale (erstes Signal (BS+) und zweites Signal (BS−)) trapezförmig sind.

10. Signalgenerator gemäß den Ansprüchen 7 und 9, dadurch gekennzeichnet, daß die genannte modulierte Sinuskurvenform (BSO) ein Zählsignal für Zwecke der Telekommunikation darstellt.

11. Signalgenerator gemäß Anspruch 1, dadurch gekennzeichnet, daß die genannte Generatorschaltung eine Impulsquelle (PS), die eine rechteckige Impulskurvenform (PW) generiert, deren Einhüllende abwechselnd positiver oder negativer als der genannte Referenzwert ist und einen Operationsverstärker (OA1), an dessen nichtinvertierenden Eingang die genannte rechteckige Impulskurvenform (PW) gelegt wird und dessen Ausgang den Betrieb der ersten (CS1) und zweiten (CS2) Stromquelle steuert, wobei diese beiden Stromquellen (Cs1, Cs2) zwischen den Polen einer Gleichstromquelle (V+, V−) in Serie geschaltet sind, und wobei der Verbindungspunkt der genannten Quellen an den invertierenden Eingang des erwähnten Verstärkers (OA1) und eine Elektrode eines Kondensators (C) dessen andere Elektrode mit dem genannten Referenzwert verbunden ist, gekoppelt ist, wobei das genannte erste Signal (BS+) an dem erwähnten Verbindungspunkt generiert wird, beinhaltet.

12. Signalgenerator gemäß Anspruch 11, dadurch gekennzeichnet, daß der genannte Verbindungspunkt an den nicht invertierenden Eingang eines als Spannungsfolger ausgelegten zweiten Operationsverstärkers (OA2) gekoppelt ist und daß der Ausgang des genannte zweiten Operationsverstärkers (OA2) mit einem invertierenden dritten Operationsverstärker (OA3) gekoppelt ist, an dessen Ausgang das genannte zweite Signal (BS−) generiert wird.

13. Signalgenerator gemäß den Ansprüchen 3 und 4, dadurch gekennzeichnet, daß jede der genannten Schaltungen aus einem Schalter besteht, der zwei gegenseitig gekoppelte PMOS- und NMOS-Transistoren umfaßt.

14. Signalgenerator gemäß Anspruch 3, dadurch gekennzeichnet, daß die genannten ersten Komparatoreingänge (BS+, BS−) über eine fünfte (NM8) und sechste (NM9) Gateschaltung mit einem ersten (I1) und zweiten (I2) Eingang eines ersten (INV1) und zweiten (INV2) Inverters verbunden sind, wobei besagte Inverter in einer geschlossenen Schleife gekoppelt sind und eine Gleichstromquelle über die genannten Inverter durch eine Gatevorrichtung (PM7, NM7) gekoppelt ist und besagte komplementäre Komparatorausgänge (CR, $\overline{CR}$) durch die Invertereingänge (I1, I2) gebildet werden.

15. Signalgenerator gemäß Anspruch 14, dadurch gekennzeichnet, daß in jedem der genannten Inverter (INV1, INV2) ein PMOS-Transistor (PM5, PM6) und ein NMOS-Transistor (NM5, NM6) inkludiert sind, deren Gateelektroden als auch Drainelektroden verbunden sind und den Invertereingang (I1, I2) bzw. -ausgang (01, 02) bilden, wobei die Sourceelektroden der PMOS-Transistoren (PM5, PM6) und die der NMOS-Transistoren (NM5, NM6) über siebente (PM7) und achte (NM8) Gateschaltungen, welche die genannten Gatevorrichtungen bilden, mit entsprechenden Polen der genannten Gleichstromquellen verbunden sind und den genannten fünften (NM8) und sechsten (NM9) Gateschaltungen, die dann leitend sind, wenn die genannten siebenten (PM7) und achten (NM8) Gateschaltungen nicht leiten und vice versa.

## Revendications

1. Générateur de signal, pour engendrer un signal (BS+) comprenant des impulsions ayant des flancs inclinés, caractérisé en ce qu'il comprend un circuit générateur (PS, BSG) qui engendre un deuxième signal (BS−) ayant, dans les intervalles entre impulsions dudit signal mentionné en premier (BS+) une amplitude telle, par rapport à ce premier signal (BS+) que ces intervalles entre impulsions peuvent être détectés par un circuit détecteur (CO) détectant une dite différence d'amplitudes et en ce que, en réponse à cela, l'amplitude dudit premier signal dans les intervalles entre impulsions est limitée par un circuit limiteur (S4) à une tension de référence.

2. Générateur de signal conforme à la revendication 1, caractérisé en ce que ledit générateur de signal (BSG) est couplé, d'une part, audit circuit détecteur qui est constitué par un circuit comparateur (CO) et, d'autre part, à une sortie de générateur (MNTC) qui est couplée audit circuit limiteur (S4), commandé par ledit circuit comparateur, le tout de telle façon que, lorsque les deux dits signaux sont appliqués à des premières entrées (BS+, BS−) dudit circuit comparateur, les périodes d'impulsions et les intervalles entre impulsions dudit premier signal (BS+) sont détectés, en conséquence de quoi ledit circuit comparateur (CO) commande ledit circuit limiteur (S4) de manière que ce dernier limite ladite amplitude à ladite valeur de référence dans lesdits intervalles entre impulsions.

3. Générateur de signal conforme à la revendication 2, caractérisé en ce que ledit circuit générateur (BSG) est couplé par un premier circuit de porte (S3) à ladite sortie de générateur qui est couplée à ladite valeur de référence par l'intermédiaire d'un deuxième circuit de porte (S4) qui constitue ledit circuit limiteur, lesdits premier (S3) et deuxième (S4) circuits de porte étant commandés par des sorties complémentaires (CR, $\overline{CR}$) dudit circuit comparateur (CO) de manière telle que le premier circuit de porte (S3) permette le passage desdits signaux seulement durant les périodes d'impulsions et en ce que ledit deuxième circuit de porte (S4) limite la sortie du générateur (MNTC) à ladite valeur de référence dans les intervalles entre impulsions.

4. Générateur de signal conforme à la revendication 2, caractérisé en ce qu'il comprend: une source d'impulsions (PS, LSIC) qui engendre des première (PDM1) et deuxième (PDM2) formes d'impulsions opposées, ainsi qu'un circuit modulateur (MOD) comprenant une paire de premières entrées de modulateur (BS+, BS−) auxquelles sont respectivement appliqués lesdits premier (BS+) et deuxième (BS−) signaux, une deuxième paire d'entrées de modulateur (PDM1, PDM2) auxquelles sont appliquées lesdites première (PDM1) et deuxième (PDM2) formes d'impulsions et une sortie de modulateur qui est couplée à ladite sortie de générateur (MNTC), lesdites premières entrées de modulateur (BS+, BS−) étant respectivement couplées par un troisième (S1) et un quatrième (S2) circuits de porte à ladite sortie de modulateur (BSO) et lesdits deuxièmes entrées de modulateur (PDM1, PDM2) constituant respectivement des entrées de commande desdits troisième (S1) et quatrième (S2) circuits de porte, de telle sorte qu'une forme d'impulsions (BSO) modulée par lesdits premier (BS+) et deuxième (BS−) signaux est engendrée sur ladire sortie de modulateur (BSO).

5. Générateur de signal conforme à la revendication 4, caractérisé en ce que lesdites première (PDM1) et deuxième (PDM2) formes d'impulsions opposées sont des formes d'impulsions à modulation de densité d'impulsions et en ce que ladite sortie de générateur (MNTC) est couplée à un dispositif de filtrage comprenant un filtre passebas, afin de transformer ladite forme d'impulsions modulée en une forme d'onde sinusoïdale modulée.

6. Générateur de signal conforme à la revendication 5, caractérisé en ce que ledit dispositif de filtrage comporte également un filtre passebande (BPF) pour permettre le passage de ladite forme d'onde sinusoïdale, tout en limitant la puissance dans la région des fréquences inférieures de celle-ci.

7. Générateur de signal conforme à la revendication 6, caractérisé en ce que cette région des fréquences inférieures est la région de la parole.

8. Générateur de signal conforme à la revendication 1, caractérisé en ce que lesdits premier (BS+) et deuxième (BS−) signaux sont mutuellement inversés par rapport à ladite valeur de référence.

9. Générateur de signal conforme à la revendication 8, caractérisé en ce que lesdits premier (BS+) et deuxième (BS−) signaux sont des signaux trapézoïdaux.

10. Générateur de signal conforme aux revendications 7 et 9, caractérisé en ce que ladite forme d'onde sinusoïdale modulée (BSO) est un signal de mesure à des fins de télécommunication.

11. Générateur de signal conforme à la revendication 1, caractérisé en ce que ledit circuit générateur comprend une source d'impulsions (PS) engendrant une forme d'onde en impulsions rectangulaires (PW) dont l'enveloppe s'étend alternativement d'un côté et de l'autre de ladite valeur de référence, un amplificateur opérationel (OA1) à l'entrée non inverseuse duquel est appliquée ladite forme d'onde en impulsions rectangulaires (PW) et dont la sortie commande le fonctionnement d'une première (CS1) et d'une deuxième (CS2) sources de courant qui sont connectées en série entre les pôles d'une source de tension continue (V+, V−), le point de jonction de ces sources étant couplé à l'entrée inverseuse dudit amplificateur (OA1) et à une armature d'un condensateur (C) dont l'autre armature est connectée à ladite valeur de référence, ledit premier signal (BS+) étant engendré audit point de jonction.

12. Générateur de signal conforme à la revendication 11, caractérisé en ce que ledit point de jonction est couplé à l'entrée non-inverseuse d'un deuxième amplificateur opérationnel (OA2) à gain unité et en ce que la sortie de ce deuxième amplificateur opérationnel (OA2) est couplée à un troisième amplificateur opérationnel inverseur (OA3) sur la sortie duquel est engendré ledit deuxième signal (BS−).

13. Générateur de signal conforme aux revendications 3 et 4, caractérisé en ce que chacun desdits circuits de porte est constitué d'un commutateur comprenant deux transistors PMOS et NMOS mutuellement connectés.

14. Générateur de signal conforme à la revendication 3, caractérisé en ce que lesdites entrées (BS+, BS−) du premier comparateur sont couplées aux première (I1) et deuxième (I2) entrées d'un premier (INV1) et d'un deuxième (INV2) inverseurs par l'intermédiaire d'un cinquième (NM8) et d'un sixième (NM9) circuits de porte, lesdits inverseurs étant couplés en une boucle fermée, une source de courant continu étant couplée, par l'intermédiaire de ces inverseurs, et à travers un dispositif de porte (PM7, NM7) et lesdites sorties de comparateur complémentaires (CR, $\overline{\text{CR}}$) étant constituées par lesdites entrées d'inverseur (I1, I2).

15. Générateur de signal conforme à la revendication 14, caractérisé en ce que chacun desdits inverseurs (INV1, INV2) comprend un transistor PMOS (PM5, PM6) et un transistor NMOS (NM5, NM6) dont les électrodes de grille, de même que les électrodes de drain sont jointes l'une à l'autre et constituent respectivement l'entrée de l'inverseur (I1, I2) et sa sortie (O1, O2), les électrodes de source des transistors PMOS (PM5, PM6) et celles des transistors NMOS (NM5, NM6) étant couplées aux pôles respectifs de ladite source de courant continu, par un septième (PM7) et un huitième (NM8) circuits de porte, constituant ledit dispositif de porte, et ledit cinquième (NM8) et sixième (NM9) circuits de porte étant conducteurs lorsque le septième (PM7) et le huitième (NM9) circuits de porte ne le sont pas et vice versa.

FIG. 1

FIG. 2

FIG. 3

FIG. 4